# FASCICULE DE BREVET EUROPEEN

(11) **EP 3 185 650 B1**
(45) Date de publication et mention de la délivrance du brevet: **02.01.2019**
(21) Numéro de dépôt: 16161138.9
(22) Date de dépôt: 18.03.2016
(51) Int. Cl.: H01S 5/026, H01S 5/042, H01S 5/068, H01S 5/062, H05B 33/08

(54) **DISPOSITIF DE COMMANDE D'UNE DIODE**
VORRICHTUNG ZUR STEUERUNG EINER DIODE
DEVICE FOR CONTROLLING A DIODE

(30) Priorité: 24.12.2015 FR 1563353
(43) Date de publication de la demande: 28.06.2017
(73) Titulaire: STMicroelectronics (ALPS) SAS, 38000 Grenoble (FR)
(72) Inventeur: ARNO, Patrik, 38360 Sassenage (FR)
(74) Mandataire: Cabinet Beaumont

(56) Documents cités:
- CN-A- 104 270 861
- CN-U- 203 722 871
- US-A1- 2005 110 469
- US-A1- 2012 133 291
- US-B1- 7 679 295

## Description

### Domaine

La présente demande concerne de façon générale les circuits électroniques et plus particulièrement les dispositifs de commande d'intensité lumineuse des diodes laser ou électroluminescentes.

### Exposé de l'art antérieur

Les dispositifs de commande d'intensité lumineuse des diodes laser ou électroluminescentes comprennent généralement une source de courant qui impose l'intensité du courant traversant la diode en fonction de l'intensité lumineuse requise.

Certains systèmes comprennent en outre une régulation de la tension appliquée aux bornes de la diode afin de minimiser la chute de tension aux bornes de la source de courant. Il subsiste néanmoins une déperdition énergétique importante due à la source de courant qui se trouve en série avec la diode.

Il existe donc un besoin d'amélioration des performances énergétiques des dispositifs de commande des diodes.

### Résumé

Ainsi, un mode de réalisation prévoit d'améliorer la consommation électrique des dispositifs de commande d'intensité lumineuse des diodes laser ou électroluminescentes.

Plus particulièrement, un mode de réalisation prévoit un dispositif de commande d'une diode comprenant :
une première borne d'application d'un premier potentiel d'alimentation ;
une seconde borne d'application d'un deuxième potentiel d'alimentation ;
un circuit d'application d'une tension sur une troisième borne destinée à être connectée à une anode de la diode, ladite troisième borne étant reliée à une première borne d'entrée dudit circuit ;
une deuxième borne d'entrée dudit circuit ; et
une résistance couplée entre ladite seconde borne et une quatrième borne destinée à être connectée à une cathode de ladite diode, ladite quatrième borne étant couplée à une troisième borne d'entrée du circuit, dans lequel la tension fournie par ledit circuit sur la troisième borne est fonction de signaux présents sur les première, deuxième et troisième bornes d'entrée dudit circuit ; et le dit circuit comprenant:
   un circuit de génération de ladite tension sur ladite troisième borne, comprenant une première borne d'entrée destinée à recevoir un signal et une seconde borne d'entrée reliée à ladite première borne d'entrée dudit circuit ;
   un comparateur dont une première entrée est reliée à ladite troisième borne d'entrée et dont une deuxième entrée est reliée à ladite deuxième borne d'entrée ; et
   un sommateur dont une première entrée est reliée à la sortie dudit comparateur et dont une deuxième entrée est reliée à une borne d'application d'une tension, la sortie du sommateur étant reliée à ladite première borne d'entrée du circuit de génération de ladite tension, dans lequel la tension appliquée sur la deuxième borne d'entrée du comparateur est de valeur strictement positive et inférieure au seuil de conduction de la diode.

Selon un mode de réalisation :
si une première tension appliquée sur la deuxième entrée du comparateur est de valeur inférieure ou égale à zéro, le circuit de génération de tension applique sur l'anode de la diode une deuxième tension de valeur égale à la tension appliquée sur ladite deuxième borne d'entrée du sommateur ;
si ladite première tension est de valeur strictement positive, le circuit de génération d'une tension applique sur l'anode de la diode une tension de valeur égale à la somme des valeurs de la tension de sortie dudit comparateur et de ladite deuxième tension.

Un mode de réalisation prévoit un système comprenant :
un dispositif selon l'un des modes de réalisation cités précédemment; et une diode.

Selon un mode de réalisation, la diode est une diode laser.

Selon un mode de réalisation, la diode est une diode électroluminescente.

Un mode de réalisation prévoit un procédé de commande d'une diode comprenant les étapes suivantes :
a) application d'une première tension sur une anode de ladite diode en fonction de la valeur d'une tension de commande ;
b) application sur une cathode de ladite diode d'une deuxième tension ayant pour valeur le produit de la valeur du courant traversant la diode et de la valeur d'une résistance couplée entre ladite cathode de la diode et la masse, l'établissement de la valeur de ladite première tension comprenant les étapes suivantes : c) initialiser une troisième tension à une valeur strictement positive et inférieure ou égale à un seuil de conduction de ladite diode ; e) fixer la valeur d'une quatrième tension à la valeur nulle si la valeur de ladite tension de commande est inférieure ou égale à zéro ; g) fixer la valeur d'une cinquième tension à la somme des valeurs des quatrième et troisième tensions.

Selon un mode de réalisation, l'établissement de la valeur de ladite première tension comprend les étapes suivantes :
d) évaluer la valeur de ladite tension de commande ;
f) fixer la valeur de ladite quatrième tension à une valeur strictement positive si la valeur de la tension de commande est strictement positive ;
h) fixer la valeur de la première tension à un multiple de la valeur de ladite cinquième tension.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
La figure 1 représente un exemple de dispositif usuel de commande d'intensité lumineuse d'une diode laser ou d'une diode électroluminescente ;
la figure 2 représente un autre exemple de dispositif usuel de commande d'intensité lumineuse d'une diode laser ou d'une diode électroluminescente ;
la figure 3 représente un dispositif de commande d'intensité lumineuse d'une diode laser ou d'une diode électroluminescente ;
la figure 4 représente un exemple de réalisation d'un circuit du dispositif de commande de la figure 3 ; et
la figure 5 illustre un mode de réalisation d'un procédé de commande d'intensité lumineuse d'une diode laser ou d'une diode électroluminescente.

### Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, les fonctions des convertisseurs continu-continu élévateurs de tension n'ont pas été détaillées, les modes de réalisation décrits étant compatibles avec des convertisseurs usuels.

Sauf précision contraire, les expressions "approximativement", "sensiblement", et "de l'ordre de" signifient à 10 % près, de préférence à 5 % près.

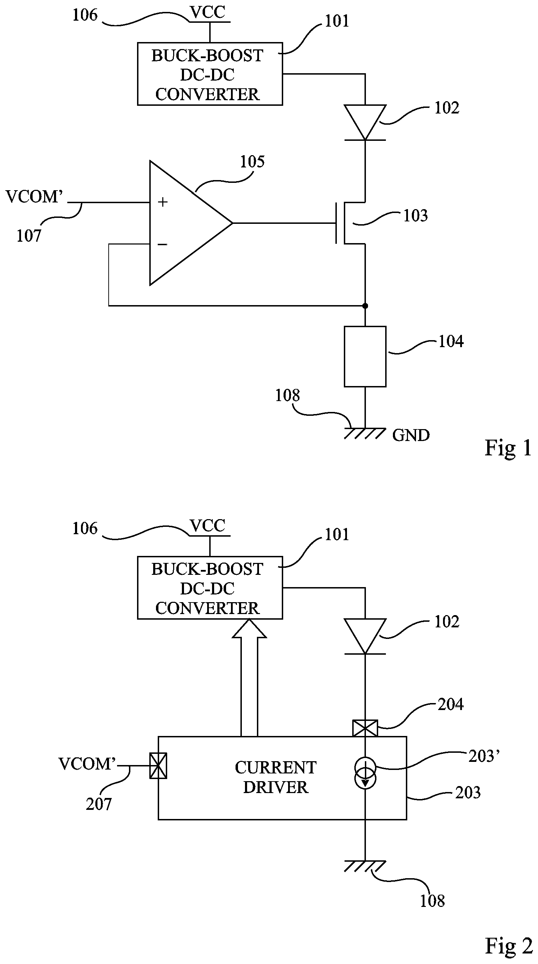

La figure 1 représente un exemple usuel de dispositif de contrôle d'intensité lumineuse d'une diode. Le dispositif comprend un convertisseur continu-continu élévateur/abaisseur de tension (BUCK-BOOST DC-DC CONVERTER) 101, une diode 102, un transistor NMOS 103 et une résistance 104, en série entre une première borne 106 d'application d'une tension d'alimentation VCC et une borne 108 de connexion à la masse. La grille du transistor 103 est couplée à la sortie d'un amplificateur différentiel 105 fonctionnant en comparateur, dont l'entrée inverseuse est couplée à la source du transistor 103 et à la borne de la résistance 104 non connectée à la masse. L'entrée non inverseuse du comparateur 105 est reliée à une borne 107 d'application d'une tension de commande VCOM'.

Le transistor 103 fonctionne en source de courant contrôlée en tension en appliquant la tension de sortie du comparateur 105 sur sa grille. Le courant qui traverse le transistor est converti en tension au niveau de sa source grâce à la résistance 104. Cette tension est ensuite comparée à la tension de commande VCOM'. La tension de sortie du comparateur 105 est ajustée en fonction du résultat de la comparaison.

Par ailleurs, afin de maintenir la diode 102 passante, le convertisseur 101 impose une tension sur son anode, de sorte que la tension aux bornes de la diode est supérieure au seuil de conduction de la diode. Le rôle du convertisseur 101 est de maintenir la tension indépendante des fluctuations éventuelles de la tension d'alimentation.

Un inconvénient de ce dispositif est la consommation électrique.

Une première cause est que la tension cible appliquée par le convertisseur 101 sur l'anode de la diode 102 est décorrélée de la régulation en courant. Cette tension cible régulée par le convertisseur 101 est définie en fonction du type de diode utilisé. Toutefois, il est nécessaire de prévoir une marge pour s'assurer que la tension appliquée aux bornes de la diode 102 est suffisante pour la maintenir passante indépendamment des tolérances de fabrication et des conditions de fonctionnement du dispositif, par exemple les variations de température. Cette marge se traduit par une consommation supplémentaire au niveau du convertisseur continu-continu 101.

Une deuxième cause de consommation électrique est la présence de la source de courant (transistor 103) en série avec la diode 102.

La figure 2 représente un autre exemple de dispositif usuel de commande d'intensité lumineuse d'une diode.

Par rapport au dispositif de la figure 1, le dispositif de la figure 2 comporte un circuit (CURRENT DRIVER) de commande du courant dans la diode qui remplace l'ensemble constitué de l'amplificateur différentiel 105, du transistor 103 et de la résistance 104 de la figure 1. Le circuit de commande 203 est d'une part couplé entre la cathode de la diode 102 et la borne d'application de la masse 108, et d'autre part relié au convertisseur continu-continu élévateur/abaisseur de tension 101. Le circuit de commande 203 comprend en outre une borne 207 d'application d'une tension de commande VCOM'.

Le circuit 203 impose un courant dans la diode 102 via une source de courant interne 203' en fonction de la tension de commande VCOM'. La différence par rapport au dispositif de la figure 1 est que la boucle de rétroaction qui existe entre le convertisseur 101 et le circuit 203 permet d'assurer l'application d'une tension minimale aux bornes de la diode 102 pour la maintenir passante indépendamment des tolérances de fabrication et des conditions de fonctionnement. Ce dispositif permet donc de s'affranchir de la marge nécessaire prévue dans le cas du dispositif de la figure 1. Il en découle une amélioration de la consommation électrique due au convertisseur 101. Toutefois, la source de courant 203', présente dans le circuit de commande 203 en série avec la diode 102, demeure une source importante de déperdition énergétique. Selon les modes de réalisation décrits ci-après, on prévoit de s'affranchir de la source de courant en série avec la diode.

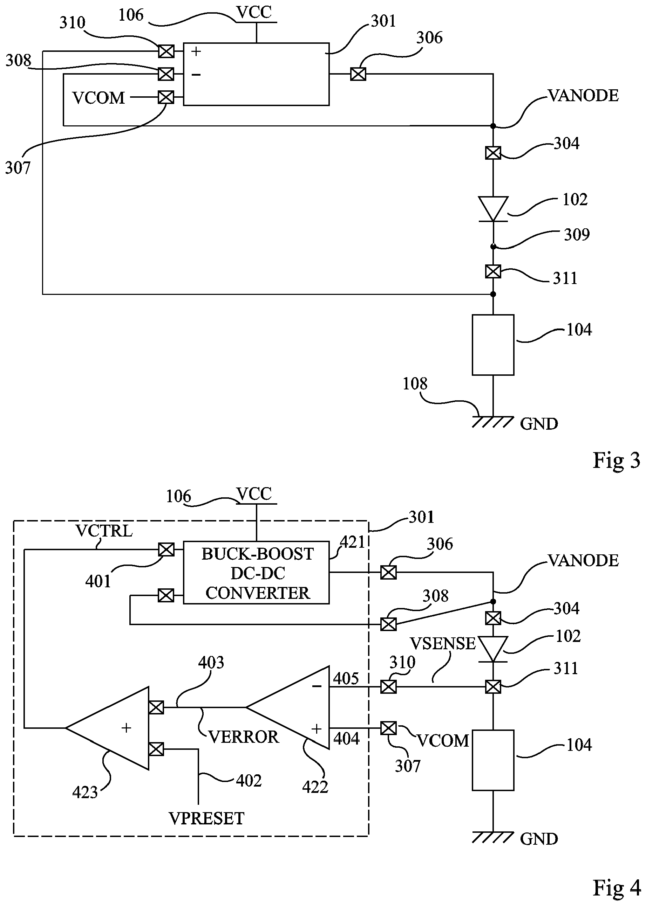

La figure 3 représente un dispositif de commande d'intensité lumineuse d'une diode laser ou d'une diode électroluminescente.

Le dispositif comprend une diode 102 et une résistance 104 en série entre une borne 306 de sortie d'un circuit 301 d'application d'une tension VANODE sur l'anode de la diode, et une borne 108 de connexion à la masse. Le circuit 301 comprend en outre une borne 310 d'entrée couplée à la cathode de la diode 102, une borne 308 d'entrée couplée à l'anode de la diode 102, une borne 307 d'entrée sur laquelle est appliquée une tension de commande VCOM, et une borne 106 d'application d'une tension d'alimentation VCC. Le circuit 301 comprend lui-même un convertisseur continu-continu qui n'est pas détaillé ici.

Le circuit 301 impose la tension VANODE sur l'anode de la diode 102 afin de contrôler le courant qui la traverse en fonction de la consigne VCOM. Cette tension appliquée sur l'anode de la diode est régulée par deux boucles de rétroaction.

Lorsque la consigne VCOM est de valeur inférieure ou égale à zéro, dans une première boucle qui couple l'anode de la diode 102 à la borne 308 du circuit 301, le circuit 301 assure aux bornes de la diode une tension VPRESET strictement positive et inférieure ou égale au seuil de conduction de la diode.

Lorsque la consigne VCOM est de valeur strictement positive, dans une deuxième boucle qui couple la cathode de la diode 102 à la borne 310 du circuit 301, le circuit 301 compare la tension appliquée aux bornes de la résistance 104 à la consigne de commande et ajuste en conséquence la tension appliquée sur l'anode de la diode à une valeur strictement supérieure à la tension VPRESET. La valeur de la tension appliquée aux bornes de la résistance 104 est obtenue par le produit de la valeur R de la résistance 104 et de la valeur du courant I traversant la diode, à l'erreur près du courant prélevé par la borne d'entrée 310. L'erreur peut être nulle selon la nature de l'étage d'entrée relié à la borne 310. Cette deuxième boucle asservit donc le courant qui traverse la diode 102 en fonction d'une tension VCOM.

On a donc réalisé un dispositif de commande d'intensité lumineuse d'une diode laser ou électroluminescente qui n'utilise pas de source de courant en série avec la diode, ce qui présente un gain en consommation énergétique.

La figure 4 représente un exemple de réalisation du circuit 301 d'application de la tension VANODE de la figure 3.

Le circuit 301 comprend un circuit 421 (BUCK BOOST DC-DC CONVERTER) de génération de la tension VANODE sur l'anode de la diode 102 comprenant une borne 401 d'entrée recevant un signal VCTRL et une autre borne d'entrée, confondue avec la borne 308, destinée à être reliée à l'anode de la diode. Le circuit 301 comprend en outre, entre la borne 310 (confondue à la borne 311) destinée à être reliée à la cathode de la diode 102 et la borne 401 d'entrée du circuit 421, un comparateur 422. Une borne 405 d'entrée du comparateur 422 est reliée à la borne 310 d'application d'une tension VSENSE sur la cathode de la diode. Une autre borne 404 d'entrée du comparateur est reliée à la borne 307 d'application de la tension de commande VCOM. Le circuit 301 comprend de plus, un sommateur 423, dont une borne 403 d'entrée est reliée à la sortie du comparateur 422 (tension VERROR), et dont une autre borne 402 d'entrée est reliée à une borne d'application d'une deuxième tension de commande VPRESET. La sortie du sommateur 423 est reliée à la borne 401 d'entrée du circuit 421. En outre, comme dans le cas de la figure 3 on ne détaille pas l'implémentation du convertisseur continu-continu compris dans le circuit 421.

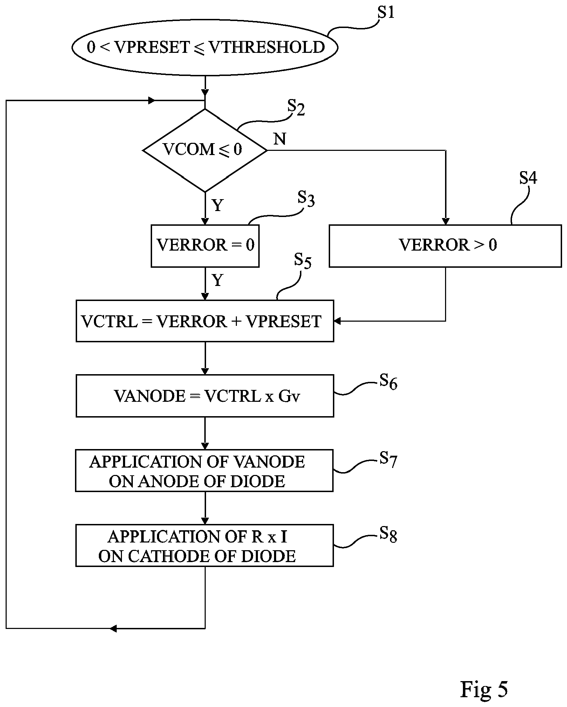

La figure 5 représente différentes étapes d'un procédé décrivant le fonctionnement du dispositif de la figure 4.

Lors d'une première étape S1, la tension VPRESET appliquée sur la borne 402 d'entrée du sommateur 423 est initialisée à une valeur strictement positive et inférieure ou égale au seuil de conduction (VTHRESHOLD) de la diode 102. Lors d'une seconde étape S2, la tension VCOM appliquée sur la borne 307 confondue avec la borne 404 d'entrée du comparateur 422 est évaluée. Si elle est de valeur inférieure ou égale à zéro (sortie Y du bloc S2), la tension VERROR du comparateur 422 prend la valeur zéro lors d'une troisième étape S3. Dans le cas contraire (sortie N du bloc S2), la tension VERROR de sortie du comparateur 422 prend pour valeur, lors d'une quatrième étape S4, le produit de la valeur du gain en tension du comparateur 422 par la valeur de la différence entre la tension VCOM et la tension VSENSE. Dans un mode de réalisation comprenant une borne d'alimentation VCC positive et une borne de masse, la tension VERROR sera positive. Lors d'une cinquième étape S5, la tension VCTRL de sortie du sommateur 423 prend pour valeur la somme des tensions VPRESET et VERROR. Lors d'une sixième étape S6, le circuit 421 applique sur l'anode de la diode la tension VANODE en fonction de la valeur de la tension VCTRL. Cette fonction est le produit par le gain Gv entre la borne 306 de sortie du circuit 421 et la borne VCTRL d'entrée. Ainsi VANODE = Gv x VCTRL. Le gain Gv est unitaire ou supérieur à 1 en fonction des besoins de l'application. Il en découle, lors d'une septième étape S7, l'application de la tension VANODE sur l'anode de la diode (APPLICATION OF VANODE ON ANODE OF DIODE) et lors d'une huitième étape S8 l'application de la tension VSENSE sur la cathode de la diode (APPLICATION OF RxI ON CATHODE OF DIODE), de valeur égale au produit de la valeur R de la résistance 104 et du courant I traversant la diode. On revient alors à la deuxième étape S2 pour le traitement d'une nouvelle valeur de tension VCOM.

On a donc réalisé un dispositif et un procédé de commande d'intensité lumineuse d'une diode laser ou électroluminescente qui n'utilise pas de source de courant en série avec la diode, ce qui présente un gain en consommation énergétique. On notera que le procédé de la figure 5 s'applique également au fonctionnement du dispositif décrit dans la figure 3.

Des modes de réalisation particuliers ont été décrits. Diverses variantes et modifications apparaîtront à l'homme de l'art. En particulier, la valeur de la tension VPRESET sera déterminée par exemple en fonction des contraintes d'activation ou de désactivation de la diode ou de toute autre contrainte liée au système. En outre l'homme de l'art choisira la structure du convertisseur continu-continu en fonction par exemple du type de diode, du type d'alimentation ou de toute autre contrainte liée aux besoins de l'application visée. Les modes de réalisation ont été décrits en faisant référence à un potentiel d'alimentation positif et à la masse. Ils se transposent sans difficulté à d'autres choix de couples de potentiels d'alimentation, y compris négatifs.

## Revendications

1. Dispositif de commande d'une diode (102) comprenant :
une première borne (106) d'application d'un premier potentiel d'alimentation ;
une seconde borne (108) d'application d'un deuxième potentiel d'alimentation ;
un circuit (301) d'application d'une tension sur une troisième borne (306) destinée à être connectée à une anode (304) de la diode, ladite troisième borne étant reliée à une première borne d'entrée (308) dudit circuit ;
une deuxième borne d'entrée (307) dudit circuit ; et
une résistance (104) couplée entre ladite seconde borne (108) et une quatrième borne (311) destinée à être connectée à une cathode (309) de ladite diode, ladite quatrième borne étant couplée à une troisième borne d'entrée (310) du circuit (301), la tension fournie par ledit circuit (301) sur la troisième borne (306) étant fonction de signaux présents sur les première, deuxième et troisième bornes (308), (307) et (310) d'entrée dudit circuit ; et ledit circuit (301) comprenant :
un circuit (421) de génération de ladite tension sur ladite troisième borne (306), comprenant une première borne (401) d'entrée destinée à recevoir un signal (VCTRL) et une seconde borne d'entrée reliée à ladite première borne (308) d'entrée dudit circuit (301) ;
un comparateur (422) dont une première entrée (405) est reliée à ladite troisième borne (310) d'entrée et dont une deuxième entrée (404) est reliée à ladite deuxième borne (307) d'entrée ; et
un sommateur (423) dont une première entrée (403) est reliée à la sortie dudit comparateur (422) et dont une deuxième entrée (402) est reliée à une borne d'application d'une tension (VPRESET), la sortie du sommateur étant reliée à ladite première borne (401) d'entrée du circuit (421) de génération de ladite tension, dans lequel la tension (VPRESET) appliquée sur la deuxième borne (402) d'entrée du comparateur est de valeur strictement positive et inférieure au seuil de conduction de la diode (102) .

2. Dispositif selon la revendication 1, dans lequel :
si une première tension (VCOM) appliquée sur la deuxième entrée (404) du comparateur (422) est de valeur inférieure ou égale à zéro, le circuit (421) de génération de tension applique sur l'anode de la diode une deuxième tension de valeur égale à la tension (VPRESET) appliquée sur ladite deuxième borne d'entrée (402) du sommateur ;
si ladite première tension est de valeur strictement positive, le circuit (421) de génération d'une tension applique sur l'anode de la diode une tension de valeur égale à la somme des valeurs de la tension (VERROR) de sortie dudit comparateur et de ladite deuxième tension (VPRESET).

3. Système comprenant :
un dispositif selon l'une quelconque des revendications précédentes ; et
une diode.

4. Système selon la revendication 3, dans lequel la diode est une diode laser.

5. Système selon la revendication 3, dans lequel la diode est une diode électroluminescente.

6. Procédé de commande d'une diode comprenant les étapes suivantes :
a) application (S7) d'une première tension (VANODE) sur une anode de ladite diode en fonction de la valeur d'une tension de commande (VCOM) ;
b) application (S8) sur une cathode de ladite diode d'une deuxième tension (VCATHODE) ayant pour valeur le produit de la valeur du courant traversant la diode et de la valeur d'une résistance couplée entre ladite cathode de la diode et la masse,
l'établissement de la valeur de ladite première tension comprenant les étapes suivantes :
c) initialiser (S1) une troisième tension (VPRESET) à une valeur strictement positive et inférieure ou égale à un seuil de conduction de ladite diode ;
e) fixer (S3) la valeur d'une quatrième tension (VERROR) à la valeur nulle si la valeur de ladite tension de commande est inférieure ou égale à zéro ;
g) fixer (S5) la valeur d'une cinquième tension (VCTRL) à la somme des valeurs des quatrième (VERROR) et troisième tensions (VPRESET).

7. Procédé selon la revendication 6, dans lequel l'établissement de la valeur de ladite première tension comprend en outre les étapes suivantes :
d) évaluer (S2) la valeur de ladite tension de commande (VCOM) ;
f) fixer (S4) la valeur de ladite quatrième tension à une valeur strictement positive si la valeur de la tension de commande est strictement positive ;
h) fixer (S6) la valeur de la première tension (VANODE) à un multiple de la valeur de ladite cinquième tension.

## Patentansprüche

1. Eine Vorrichtung zum Steuern einer Diode (102), die Folgendes aufweist:
einen ersten Anschluss (106) zum Anlegen einer ersten Leistungsversorgungsspannung;
einen zweiten Anschluss (108) zum Anlegen einer zweiten Leistungsversorgungsspannung;
eine Schaltung (301) zum Anlegen einer Spannung an einen dritten Anschluss (306), der konfiguriert ist, um mit einer Anode (304) der Diode verbunden zu werden, wobei der dritte Anschluss mit einem ersten Eingangsanschluss (308) der Schaltung verbunden ist;
einen zweiten Eingangsanschluss (307) der Schaltung; und
einen Widerstand (104), der zwischen dem zweiten Anschluss (108) und einem vierten Anschluss (311) gekoppelt ist und konfiguriert ist, um mit einer Kathode (309) der Diode verbunden zu werden, wobei der vierte Anschluss mit einem dritten Eingangsanschluss (310) der Schaltung (301) gekoppelt ist, wobei die von der Schaltung (301) an den dritten Anschluss (306) vorgesehene Spannung eine Funktion von Signalen ist, die an den ersten, zweiten und dritten Eingangsanschlüssen (308), (307) und (310) der Schaltung anliegen; und die Schaltung (301) Folgendes aufweist:
eine Schaltung (421) zum Erzeugen der Spannung an dem dritten Anschluss (306), die einen ersten Eingangsanschluss (401) aufweist, der konfiguriert ist zum Empfangen eines Signals (VCTRL), und einen zweiten Eingangsanschluss, der mit dem ersten Eingangsanschluss (308) der Schaltung (301) verbunden ist;
einen Komparator (422) mit einem ersten Eingang (405), der mit dem dritten Eingangsanschluss (310) verbunden ist, und dessen zweiter Eingang (404) mit dem zweiten Eingangsanschluss (307) verbunden ist; und
einen Addierer (423) mit einem ersten Eingang (403), der mit dem Ausgang des Komparators (422) verbunden ist, und dessen zweiter Eingang (402) mit einem Anschluss zum Anlegen einer Spannung (VPRESET) verbunden ist, wobei der Ausgang des Addierers mit dem ersten Eingangsanschluss (401) der Schaltung (421) verbunden ist, um die Spannung zu erzeugen, wobei die Spannung (VPRESET), die an den zweiten Eingangsanschluss (402) zu dem Komparator angelegt wird, einen positiven Wert besitzt, der kleiner als der Leitungsschwellenwert der Diode (102) ist.

2. Vorrichtung nach Anspruch 1, wobei:
wenn eine erste Spannung (VCOM), die an den zweiten Eingang (404) des Komparators (422) angelegt wird, einen Wert hat, der kleiner oder gleich Null ist, legt die Spannungserzeugungsschaltung (421) an die Anode der Diode eine zweite Spannung an, die einen Wert hat, der gleich der Spannung (VPRESET) ist, die an den zweiten Eingangsanschluss (402) des Addierers angelegt wird;
wenn die erste Spannung einen positiven Wert hat, legt die Spannungserzeugungsschaltung (421) an die Anode der Diode eine Spannung an, die einen Wert hat, der gleich der Summe der Werte der Ausgangsspannung (VERROR) des Komparators und der zweiten Spannung (VPRESET) ist.

3. Ein System, das Folgendes aufweist:
die Vorrichtung nach einem der vorhergehenden Ansprüche; und
eine Diode.

4. System nach Anspruch 3, wobei die Diode eine Laserdiode ist.

5. System nach Anspruch 3 wobei die Diode eine Licht-emittierende Diode ist.

6. Verfahren zum Steuern einer Diode, das die folgenden Schritte aufweist:
a) Anlegen (S7) einer ersten Spannung (VANODE) an eine Anode der Diode gemäß dem Wert einer Steuerspannung (VCOM);
b) Anlegen (S8) einer zweiten Spannung (VCATHODE) an eine Kathode der Diode, die als einen Wert das Produkt aus dem Wert des durch die Diode fließenden Stroms und dem Wert eines Widerstandes, der zwischen der Kathode der Diode und der Masse gekoppelt ist, hat,
wobei das Einstellen des Werts der ersten Spannung die folgenden Schritte aufweist:
c) Initialisieren (S1) einer dritten Spannung (VPRESET) zu einem positiven Wert, der kleiner oder gleich eines Leitungsschwellenwertes der Diode ist;
e) Einstellen (S3) des Wertes einer vierten Spannung (VERROR) auf den Nullwert, wenn der Wert der Steuerspannung kleiner oder gleich Null ist;
g) Einstellen (S5) des Wertes einer fünften Spannung (VCTRL) auf die Summe der Werte der vierten (VERROR) und dritten Spannung (VPRESET).

7. Verfahren nach Anspruch 6, wobei das Einstellen des Wertes der ersten Spannung ferner folgende Schritte aufweist:
d) Schätzen (S2) des Wertes der Steuerspannung (VCOM);
f) Einstellen (S4) des Wertes der vierten Spannung zu einem positiven Wert, wenn der Wert der Steuerspannung positiv ist;
h) Einstellen (S6) des Wertes der ersten Spannung (VANODE) zu einem Vielfachen des Wertes der fünften Spannung.

## Claims

1. A device for controlling a diode (102) comprising:
a first terminal (106) of application of a first power supply voltage;
a second terminal (108) of application of a second power supply voltage;
a circuit (301) of application of a voltage onto a third terminal (306) configured to be connected to an anode (304) of the diode, said third terminal being connected to a first input terminal (308) of said circuit;
a second input terminal (307) of said circuit; and
a resistor (104) coupled between said second terminal (108) and a fourth terminal (311) configured to be connected to a cathode (309) of said diode, said fourth terminal being coupled to a third input terminal (310) of the circuit (301), the voltage provided by said circuit (301) on the third terminal (306) being a function of signals present on the first, second, and third input terminals (308), (307), and (310) of said circuit; and said circuit (301) comprising:
a circuit (421) for generating said voltage on said third terminal (306), comprising a first input terminal (401) configured to receive a signal (VCTRL) and a second input terminal connected to said first input terminal (308) of said circuit (301) ;
a comparator (422) having a first input (405) connected to said third input terminal (310) and having a second input (404) connected to said second input terminal (307); and
an adder (423) having a first input (403) connected to the output of said comparator (422) and having a second input (402) connected to a terminal of application of a voltage (VPRESET), the output of the adder being connected to said first input terminal (401) of the circuit (421) for generating said voltage, wherein the voltage (VPRESET) applied onto the second input terminal (402) to the comparator has a positive value smaller than the conduction threshold of the diode (102).

2. The device of claim 1, wherein:
if a first voltage (VCOM) applied onto the second input (404) of the comparator (422) has a value smaller than or equal to zero, the voltage generation circuit (421) applies onto the anode of the diode a second voltage having a value equal to the voltage (VPRESET) applied onto said second input terminal (402) of the adder;
if said first voltage has a positive value, the voltage generation circuit (421) applies onto the anode of the diode a voltage having a value equal to the sum of the values of the output voltage (VERROR) of said comparator and of said second voltage (VPRESET).

3. A system comprising:
the device of any of the foregoing claims; and
a diode.

4. The system of claim 3, wherein the diode is a laser diode.

5. The system of claim 3, wherein the diode is a light-emitting diode.

6. A method of controlling a diode comprising the steps of:
a) applying (S7) a first voltage (VANODE) onto an anode of said diode according to the value of a control voltage (VCOM);
b) applying (S8) onto a cathode of said diode a second voltage (VCATHODE) having as a value the product of the value of the current flowing through the diode and of the value of a resistor coupled between said cathode of the diode and the ground,
the setting of the value of said first voltage comprising the steps of:
c) initializing (S1) a third voltage (VPRESET) to a positive value smaller than or equal to a conduction threshold of said diode;
e) setting (S3) the value of a fourth voltage (VERROR) to the zero value if the value of said control voltage is smaller than or equal to zero;
g) setting (S5) the value of a fifth voltage (VCTRL) to the sum of the values of the fourth (VERROR) and third voltages (VPRESET).

7. A method according to claim 6, wherein the setting of the value of said first voltage further comprises the steps of:
d) estimating (S2) the value of said control voltage (VCOM);
f) setting (S4) the value of said fourth voltage to a positive value if the value of the control voltage is positive;
h) setting (S6) the value of the first voltage (VANODE) to a multiple of the value of said fifth voltage.
